# EUROPEAN PATENT SPECIFICATION

(11) **EP 2 799 897 B1**
(45) Date of publication and mention of the grant of the patent: **17.11.2021**
(21) Application number: 14166798.0
(22) Date of filing: 01.05.2014
(51) Int. Cl.: G01C 21/20, G01C 15/00, G09B 29/00, G01S 5/02

(54) **Method, apparatus and computer program product for aligning floor plans in multi floor buildings**
Verfahren, Vorrichtung und Computerprogrammprodukt zur Bodenausrichtung in Gebäuden mit mehreren Boden
Procédé, dispositif et programme d'ordinateur d'alignement des planchers dans des bâtiments à plusieurs étages

(30) Priority: 01.05.2013 US 201313874998
(43) Date of publication of application: 05.11.2014
(73) Proprietor: NetAlly, LLC, Los Angeles, CA 90067 (US)
(72) Inventor: Natarajan, Sumathi, Sunnyvale, CA 94087 (US)
(74) Representative: Hargreaves, Timothy Edward

(56) References cited:
- US-A1- 2004 186 847
- US-A1- 2008 077 326
- Ekahau: "Ekahau Site Survey, User Guide V5.0", , 2010, XP002735871, Retrieved from the Internet: URL:http://www.sitesurvey.de/downloads/201 0_06_ess-user-guide_v5.pdf [retrieved on 2015-02-12]

## Description

### FIELD OF THE INVENTION

The invention claimed relates to floor alignment in multi floor buildings in the context of site survey techniques for wireless networks.

### BACKGROUND OF THE INVENTION

Wireless networks have become increasingly popular as network services are not tied to a specific connection point. It has recently been discovered that observations of a signal quality value in a wireless network, such as signal strength, bit error rate/ratio, signal-to-noise ratio, and the like, can be used to locate a mobile communication device.

When a wireless network is set up, it is recommended to carry out a site survey in which such signal quality parameters are determined at various locations to ensure that the wireless network provides adequate coverage. In a normal site survey, the locations in which the measurements are made are known by other means, such as from a floor plan or other map. In some applications regarding a wireless network setup, it is often necessary to align adjacent floor plans to be orientated atop one another based upon prescribed reference points.

"Ekahau Site Survey, User Guide V5.0", 1 January 2010 (http://www.sitesurvey.de/downloads/2010_06_ess-user-guide_v5.pdf) describes user actions for selecting floor alignment points when designing Wi-Fi networks. US 2008/0077326 describes methods and systems for locating and monitoring the status of people and assets, for example firefighters, in environments where GPS systems do not operate.

### SUMMARY OF THE INVENTION

The invention comprises a method for aligning floor plans of a building structure by an electronic device according to appended claim 1, an apparatus having a graphical user interface for aligning floor plans of a building structure according to appended claim 7 and a computer program product according to claim 12.

### BRIEF DESCRIPTION OF THE DRAWINGS

The accompanying appendices and/or drawings illustrate various non-limiting, example, inventive aspects in accordance with the present disclosure:
FIG. 1 illustrates a system overview and data-flow in one embodiment of system operation;
FIG. 2 illustrates various graphical views of floor plans to be aligned with one another; and
FIG. 3 illustrates a process for aligning the floor plans of FIG. 2 using the system of FIG. 1.

### DETAILED DESCRIPTION OF CERTAIN EMBODIMENTS

The illustrated embodiments are now described more fully with reference to the accompanying drawings wherein like reference numerals identify similar structural/functional features. The illustrated embodiments are not limited in any way to what is illustrated as the illustrated embodiments described below are merely exemplary, which can be embodied in various forms, as appreciated by one skilled in the art. Therefore, it is to be understood that any structural and functional details disclosed herein are not to be interpreted as limiting, but merely as a basis for the claims and as a representation for teaching one skilled in the art to variously employ the discussed embodiments. Furthermore, the terms and phrases used herein are not intended to be limiting but rather to provide an understandable description of the illustrated embodiments.

Unless defined otherwise, all technical and scientific terms used herein have the same meaning as commonly understood by one of ordinary skill in the art to which this invention belongs. Although any methods and materials similar or equivalent to those described herein can also be used in the practice or testing of the illustrated embodiments, exemplary methods and materials are now described.

It must be noted that as used herein and in the appended claims, the singular forms "a", "an," and "the" include plural referents unless the context clearly dictates otherwise. Thus, for example, reference to "a stimulus" includes a plurality of such stimuli and reference to "the signal" includes reference to one or more signals and equivalents thereof known to those skilled in the art, and so forth.

It is to be appreciated the illustrated embodiments discussed below are preferably a software algorithm, program or code residing on computer useable medium having control logic for enabling execution on a machine having a computer processor. The machine typically includes memory storage configured to provide output from execution of the computer algorithm or program. As used herein, the term "software" is meant to be synonymous with any code or program that can be in a processor of a host computer, regardless of whether the implementation is in hardware, firmware or as a software computer product available on a disc, a memory storage device, or for download from a remote machine. The embodiments described herein include such software to implement the equations, relationships and algorithms described above. One skilled in the art will appreciate further features and advantages of the illustrated embodiments based on the above-described embodiments. Accordingly, the illustrated embodiments are not to be limited by what has been particularly shown and described, except as indicated by the appended claims.

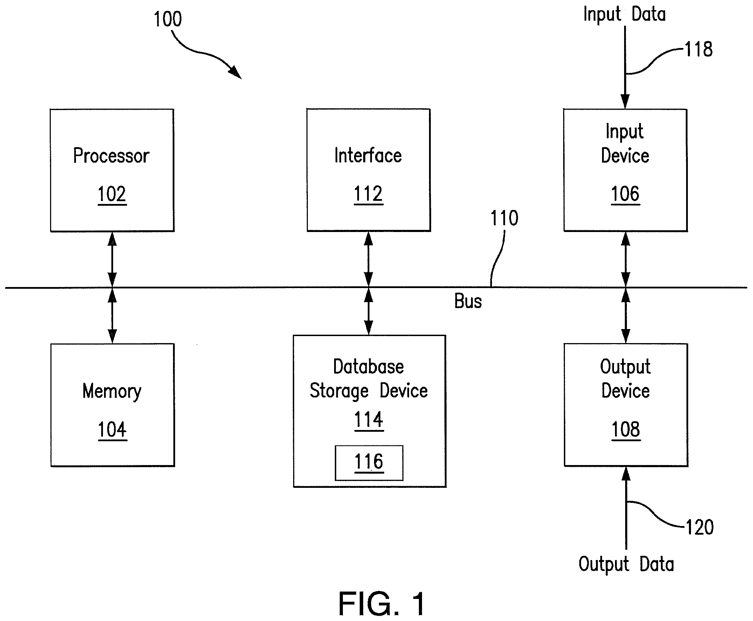

Turning now descriptively to the drawings, in which similar reference characters denote similar elements throughout the several views, Fig. 1 depicts an exemplary general-purpose computing system in which below illustrated embodiments may be implemented.

A generalized computering embodiment in which the illustrated embodiments can be realized is depicted in FIG. 1 illustrating a processing system 100 which generally comprises at least one processor 102, or processing unit or plurality of processors, memory 104, at least one input device 106 and at least one output device 108, coupled together via a bus or group of buses 110. In certain embodiments, input device 106 and output device 108 could be the same device. An interface 112 can also be provided for coupling the processing system 100 to one or more peripheral devices, for example interface 112 could be a PCI card or PC card. At least one storage device 114 which houses at least one database 116 can also be provided. The memory 104 can be any form of memory device, for example, volatile or non-volatile memory, solid state storage devices, magnetic devices, etc. The processor 102 could comprise more than one distinct processing device, for example to handle different functions within the processing system 100. Input device 106 receives input data 118 and can comprise, for example, a keyboard, a pointer device such as a pen-like device or a mouse, audio receiving device for voice controlled activation such as a microphone, data receiver or antenna such as a modem or wireless data adaptor, data acquisition card, etc. Input data 118 could come from different sources, for example keyboard instructions in conjunction with data received via a network. Output device 108 produces or generates output data 120 and can comprise, for example, a display device or monitor in which case output data 120 is visual, a printer in which case output data 120 is printed, a port for example a USB port, a peripheral component adaptor, a data transmitter or antenna such as a modem or wireless network adaptor, etc. Output data 120 could be distinct and derived from different output devices, for example a visual display on a monitor in conjunction with data transmitted to a network. A user could view data output, or an interpretation of the data output, on, for example, a monitor or using a printer. The storage device 114 can be any form of data or information storage means, for example, volatile or non-volatile memory, solid state storage devices, magnetic devices, etc.

In use, the processing system 100 is adapted to allow data or information to be stored in and/or retrieved from, via wired or wireless communication means, at least one database 116. The interface 112 may allow wired and/or wireless communication between the processing unit 102 and peripheral components that may serve a specialized purpose. Preferably, the processor 102 receives instructions as input data 118 via input device 106 and can display processed results or other output to a user by utilizing output device 108. More than one input device 106 and/or output device 108 can be provided. It should be appreciated that the processing system 100 may be any form of terminal, server, specialized hardware, or the like.

It is to be appreciated that the processing system 100 may be a part of a networked communications system. Processing system 100 could connect to a network, for example the Internet or a WAN. Input data 118 and output data 120 could be communicated to other devices via the network. The transfer of information and/or data over the network can be achieved using wired communications means or wireless communications means. A server can facilitate the transfer of data between the network and one or more databases. A server and one or more databases provide an example of an information source.

Thus, the processing computing system environment 100 illustrated in FIG. 1 may operate in a networked environment using logical connections to one or more remote computers. The remote computer may be a personal computer, a tablet device, smart phone device, a server, a router, a network PC, a peer device, or other common network node, and typically includes many or all of the elements described above.

It is to be further appreciated that the logical connections depicted in FIG. 1 include a local area network (LAN) and a wide area network (WAN), but may also include other networks such as a personal area network (PAN). Such networking environments are commonplace in offices, enterprise-wide computer networks, intranets, and the Internet. For instance, when used in a LAN networking environment, the computing system environment 100 is connected to the LAN through a network interface or adapter. When used in a WAN networking environment, the computing system environment typically includes a modem or other means for establishing communications over the WAN, such as the Internet. The modem, which may be internal or external, may be connected to a system bus via a user input interface, or via another appropriate mechanism. In a networked environment, program modules depicted relative to the computing system environment 100, or portions thereof, may be stored in a remote memory storage device. It is to be appreciated that the illustrated network connections of FIG. 1 are exemplary and other means of establishing a communications link between multiple computers may be used.

FIG. 1 is intended to provide a brief, general description of an illustrative and/or suitable exemplary environment in which embodiments of the below described present invention may be implemented. FIG. 1 is an example of a suitable environment and is not intended to suggest any limitation as to the structure, scope of use, or functionality of an embodiment of the present invention. A particular environment should not be interpreted as having any dependency or requirement relating to any one or combination of components illustrated in an exemplary operating environment. For example, in certain instances, one or more elements of an environment may be deemed not necessary and omitted. In other instances, one or more other elements may be deemed necessary and added.

In the description that follows, certain embodiments may be described with reference to acts and symbolic representations of operations that are performed by one or more computing devices, such as the computing system environment 100 of FIG. 1. As such, it will be understood that such acts and operations, which are at times referred to as being computer-executed, include the manipulation by the processor of the computer of electrical signals representing data in a structured form. This manipulation transforms the data or maintains them at locations in the memory system of the computer, which reconfigures or otherwise alters the operation of the computer in a manner understood by those skilled in the art. The data structures in which data is maintained are physical locations of the memory that have particular properties defined by the format of the data. However, while an embodiment is being described in the foregoing context, it is not meant to be limiting as those of skill in the art will appreciate that the acts and operations described hereinafter may also be implemented in hardware.

It is to be further appreciated, embodiments may be implemented with numerous other general-purpose or special-purpose computing devices and computing system environments or configurations. Examples of well-known computing systems, environments, and configurations that may be suitable for use with an embodiment include, but are not limited to, personal computers, handheld or laptop devices, personal digital assistants, tablet devices, smart phone devices, multiprocessor systems, microprocessor-based systems, set top boxes, programmable consumer electronics, network, minicomputers, server computers, game server computers, web server computers, mainframe computers, and distributed computing environments that include any of the above systems or devices. Embodiments may be described in a general context of computer-executable instructions, such as program modules, being executed by a computer. Generally, program modules include routines, programs, objects, components, data structures, etc., that perform particular tasks or implement particular abstract data types. An embodiment may also be practiced in a distributed computing environment where tasks are performed by remote processing devices that are linked through a communications network. In a distributed computing environment, program modules may be located in both local and remote computer storage media including memory storage devices.

With the exemplary computing system environment 100 of FIG. 1 being generally shown and discussed above, it is to be understood the below illustrated embodiments for aligning floor plan images of different sizes/orientation in a multi-floor building such that floors are located in a position and orientation that reflects a physical layout of a building may be used in conjunction with an application/product such as AirMagnet Survey provided by FLUKE Networks™.

AirMagnet Survey is a computer implemented planning and designing tool which provides site surveys for 802.11a/b/ g/n/4.9 GHz indoor and outdoor wireless network. It is operational to automatically gather Wi-Fi and RF spectrum information relating to an enterprise network, preferably using multiple data collection methods, including real-world measurements. It generates detailed Wi-Fi performance maps of the results for network deployment, capacity planning and optimization. AirMagnet is operational to enable users to perform Wi-Fi site surveying with ability to map out signal, noise and user performance including 802.1 In deployments, multi-floor deployments, outdoor surveys, network design verification, voice readiness verification and surveys, RF spectrum analysis, etc.

After a survey is completed, users can simulate a variety of changes to the network and preview the impacts. This includes changing Access Point (AP) transmit power, channel, SSID settings and/or the addition of environmental noise. Users can also simulate moving APs to new locations and preview the effect of adding additional APs. It provides an automated channel plan for APs that avoids interference and over-allocation.

Additional features include providing a complete view of wireless statistics, including distribution of Signal, Noise, Signal/Noise, WLAN throughput, PHY data rates, Retry Rates, and Packet Losses. Measure the total cumulative interference from all sources that can impact the performance APs. Sort results based on SSID or channel to balance RF issues against VLAN and service level requirements. Identify areas of over-provisioning or where clients are prone to consistent roaming or "thrashing" between APs. Leverage multiple adapters plugged into a common computering device to emulate client behavior while reducing site surveying time, effort and cost. Provide side-by-side visualizations of differences between separate surveys to illustrate if a site's wireless environment has changed over time. Facilitate network design to minimize RF spillage outside a building area. Perform voice surveys over a network to ensure a network design is in-line with recommendations of a phone vendor and to validate and plot phone call quality, capacity and other voice specific parameters at locations on a floor map to identify and minimize issues causing low call quality. Inspect multiple floors of a single building to see if AP signals are bleeding to adjacent floors to enable networks to reuse services of a single AP across multiple floors in order to lower equipment and deployment costs.

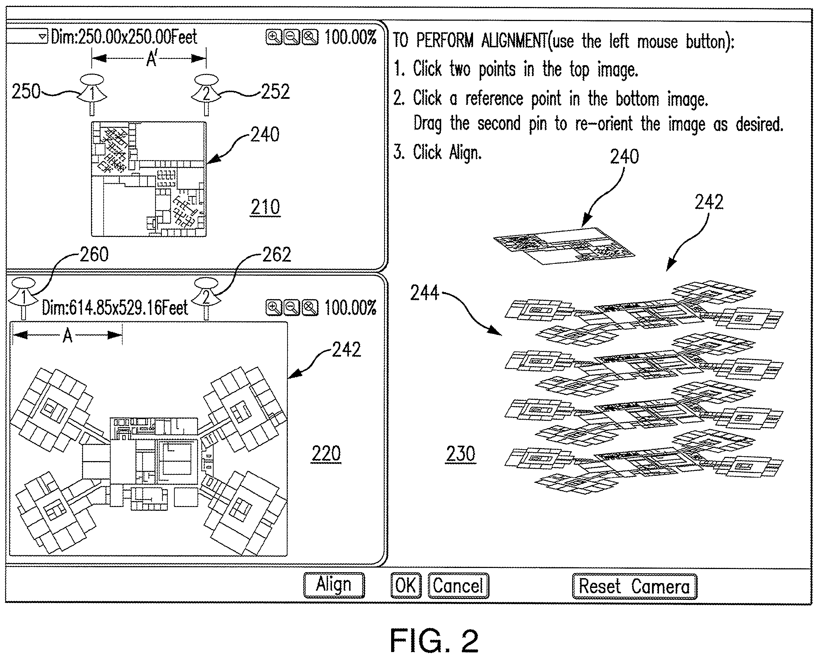

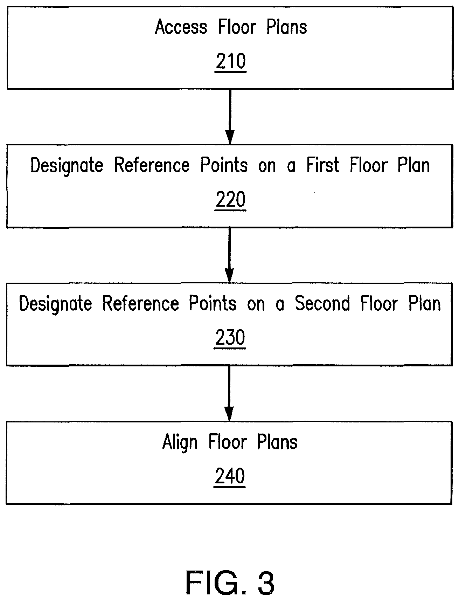

With the elements and certain functionality of the illustrated embodiments described above, and with now to FIGS. 2 and 3, the process for aligning floor plan images of different sizes/orientation in a multi-floor building such that floors are located in a position and orientation that reflects a physical layout of a building will now be described. It is also to be appreciated, the illustrated embodiments use above described system 100, or components thereof, for performing the below described process.

With reference now to FIG. 3, shown is a flow chart demonstrating implementation of the various exemplary embodiments. It is to be appreciated FIG. 2 depicts screen shots (210, 220 and 230) of a Graphical User Interfaces (GUI) as generated by system 100 in accordance with the illustrated embodiments.

Starting at step 300, system 100 acquires at least first and second floor plans 240, 242 (as selected from a user via preferably interface 112) from a multi-floor building 244 which are to be aligned with one another as they are disposed adjacent one another in the aforesaid multi-floor building. Screen 210 (via output device 108) shows a user selected first floor plan 240 which is to be disposed atop a second floor plan 242 from a building structure they originate from. It is to be appreciated the floor plans (240, 242) may be of a different size and arranged in a different orientation relative to one another. For instance, a user may be interested in an entire first floor (242) of a building structure and only a partial floor plan (240) of a second floor of a building structure.

Next, a user (preferably via interface 112) designates first and second 250, 252 reference points on a top floor plan 240 which are to be used for aligning the top floor plan 240 with the bottom floor plan 242, step 320. The user then designates a first reference 260 on a bottom floor plan 242 (which is to align with the aforesaid first reference point 250 of the top floor plan 240) whereafter the computer system 100 positions a second reference point 262 on the bottom floor plan 242 at a distance (A) from the first reference 260 which is equidistant relative to the distance (A¹) of the second reference point 252 from the first reference point 250 on the top floor plan 240. Via an input device 106 of system 100, a user moves the positioning of the second reference point 262 on the bottom floor 242 with the constraint, and under control of system 100, that it remains at the aforesaid radius (A) from the first reference point 260, step 230. The first and second reference points 250, 252 of the top floor plan 240 are to match up with the first and second reference points 260, 262 on the bottom floor plan 242.

System 100 then aligns the top and bottom floors 240, 242 (screen 230) with one another by vertically aligning the first reference point 250 of the top floor plan 240 with the first reference point 260 of the bottom floor plan 242, and by vertically aligning the second reference point 252 of the top floor plan 240 with the second reference point 262 of the bottom floor plan 242, step 240.

It is to be appreciated each of the aforesaid first and second reference points 250, 252, 260, 262 preferably has mapping or gird like coordinates associated with it such that system 100 may use them to align the reference points with one another as mentioned above. The mapping coordinates may be embedded in each floor plan preferably based on manually calibrated floor plans. In other alternative embodiments, the mapping coordinates be derived from GPS services or other similar methods for facilitating such mapping coordinates.

Additionally, system 100 may be operational and functional to provide graphical animation of the at least first and second floor plans being aligned with one another when the first provided reference point of the first floor plan is being vertically arranged relative to the first reference point provided on the second floor and when the second provided reference point of the first floor plan is being vertically arranged relative to the second reference point provided on the second floor.

Thus, the aforesaid user top and bottom floor plans 240, 242 are aligned with one another in accordance with how they are disposed relative to one another in a building structure. System 100 is then enabled to perform the aforesaid wireless diagnostics as mentioned above at least in regards to the aforesaid user selected top and bottom floor plans 240, 242.

## Claims

1. A method for aligning floor plans by an electronic device (100), the method comprising the steps of:
accessing at least a floor plan (240) and a further floor plan (242) of a predefined building structure;
receiving a designation from a user of first and second reference points (250, 252) on the floor plan (240), wherein the second reference point (252) on the floor plan (240) is at a distance A' from the first reference point (250) on the floor plan (240);
receiving designation from the user of a first reference point (260) on the further floor plan (242) and **characterised by** the further steps of :
positioning, by the electronic device (100) a second reference point (262) on the further floor plan (242) at a distance A from the first reference point (260) on the further floor plan (242), wherein the distance A between the first and second reference points (260, 262) on the further floor plan (242) is equidistant relative to the distance A' between the first and second reference points (250, 252) on the floor plan (240);
moving, by the user via an input device (106) of the electronic device (100), the position of the second reference point (262) on the further floor plan (242), wherein the moving is under the control of the electronic device (100) with the constraint that the second reference point (262) remains at distance A from the first reference point (260); and
aligning at least the floor and the further floor in accordance with the predefined building structure, the aligning comprising vertically aligning the first provided reference point (250) of the floor plan (240)relative to the first reference point (260) provided on the further floor plan (242) and vertically aligning the second provided reference point (252) of the floor plan (240) relative to the second reference point (262) provided on the further floor plan (242).

2. A method as recited in claim 1 further including providing graphical animation of at least the floor plan (240) and the further floor plan (242) being aligned with one another when the first provided reference point of the floor plan (240) is being vertically aligned with the first reference point provided on the further floor plan (242) and when the second provided reference point of the floor plan (240) is being vertically aligned with the second reference point provided on the further floor plan (242).

3. A method as recited in claim 1 wherein at least one of:-
the electronic device (100) has a graphical display (108) for imaging alignment of at least the floor plan (240) and the further floor plan (242);
the graphical display (108) has a touch screen user interface.

4. A method as recited in claim 1 further including the step of accessing in the electronic device at least the floor plan (240) and the further floor plan (242).

5. A method as recited in claim 1 wherein each of the first and second reference points has associated mapping coordinates, and
optionally:-
the mapping coordinates associated with the first and second reference points are retrieved from mapping coordinates provided in the floor plans (240, 242).

6. An apparatus having a Graphical User Interface (GUI) for aligning floor plans (240, 242) of a building structure, comprising:
a processor (102) adapted to execute one or more processes; and
a memory (104) configured to store a instructions executable by the processor (102), the instructions, when executed by the processor (102), cause the processor (102) to:
access at least a floor plan (240) and a further floor plan (242) of a predefined building structure;
receive a designation from a user of first and second reference points (250, 252) on the floor plan (240), wherein the second reference point (252) is at a distance A' from the first reference point (250);
receive from the user a designation of a first reference point (260) on the further floor plan (242);
position a second reference point (262) on the further floor plan (242), as computed by the processor (102), at a distance A from the first reference point (260) of the further floor plan (242), wherein the distance A is equidistant relative to the distance A' between the first and second reference points (250, 252) on the floor plan (240);
move, in response to an input from the user via an input device (106), the position of the second reference point (262) on the further floor plan (242), wherein the moving is under the control of the processor (102) with the constraint that the second reference point (262) on the further floor plan (242) remains at distance A from the first reference point (260) on the further floor plan (242); and
align of the floor and the further floor in accordance with the predefined building structure, the aligning comprising vertically aligning the first provided reference point (250) of the floor plan (240) with the first reference point (260) provided on the further floor plan (242) and vertically aligning the second provided reference point (252) of the floor plan (240) with the second reference point (262) provided on the further floor plan (242).

7. The apparatus recited in claim 6 further including instructions for causing the processor (102) to provide graphical animation on the GUI of at least the floor plan (240) and the further floor plan (242) being aligned with one another when the first provided reference point (250) of the floor plan (240) is being vertically aligned with the first reference point (260) provided on the further floor plan (242) and the second provided reference point (252) of the floor plan (240) is being vertically aligned with the second reference point (262) provided on the further floor plan (242).

8. The apparatus as recited in claim 6 wherein at least one of:-
the GUI has a touch screen user interface;
the apparatus further includes instructions for causing the processor (102) to access from an external input at least the floor plan (240) and the further floor plan (242).

9. The apparatus as recited in claim 6 wherein each of the first and second reference points has associated mapping coordinates, and
optionally:-
the mapping coordinates associated with the first and second reference points are retrieved from mapping coordinates provided in the floor plans (240, 242).

10. The apparatus as recited in claim 6 further including instructions for causing the processor (102) to enable a user to interact with the GUI to provide the at least first and second reference points on each of the floor plan (240) and the further floor plan (242).

11. A computer program product comprising a computer useable medium having control logic stored therein for causing a computer to align floor plans of a building structure, said control logic comprising:
code for causing the computer to access at least a floor plan (240) and a further floor plan (242) of a predefined building structure;
code for causing the computer to receive user designated first and second reference points (250, 252) on the floor plan (240), wherein the second reference point (252) on the floor plan (240) is at a distance A' from the first reference point (250) on the floor plan (240);
code for causing the computer to receive a user designated first reference point (260) on the further floor plan (242);
code for causing the computer to position a second reference point (262) on the further floor plan (242) at a distance A from the first reference point (260) on the further floor plan (242), wherein the distance A between the first and second reference is equidistant relative to the distance A' between the first and second reference points (250, 252) on the floor plan (240);
code for causing the computer to move, in response to an input from the user via an input device (106), the position of the second reference point (262) on the further floor plan (242), wherein the moving is under the control of the processor (102) with the constraint that the second reference point (262) on the further floor plan (242) remains at distance A from the first reference point (260) on the further floor plan (242);
and
code for causing the computer to align the floor and the further floor in accordance with the predefined building structure, the aligning comprising vertically aligning the first provided reference point (250) of the floor plan (240) with the first reference point (260) provided on the further floor plan (242) and vertically aligning the second provided reference point (252) of the floor plan (240) with the second reference point (262) provided on the further floor plan (242).

12. The computer program product as recited in claim 11 further including code for causing the computer to provide graphical animation on a graphical User Interface (GUI) of at least the floor plan (240) and the furthe floor plan (242) being aligned with one another when the first provided reference point (250) of the floor plan (240) is being aligned with to the first reference point (260) provided on the further floor plan (242) and the second provided reference point (252) of the floor plan (240) is being aligned with to the second reference point (262) provided on the further floor plan (242).

13. The computer program product as recited in claim 11 wherein each of the first and second reference points has associated mapping coordinates and wherein the mapping coordinates associated with the first and second reference points are retrieved from mapping coordinates provided in the floor plans (240, 242).

## Patentansprüche

1. Verfahren zur Ausfluchtung von Bodenplänen durch eine elektronische Vorrichtung (100), wobei das Verfahren folgende Schritte umfasst:
Zugreifen auf mindestens einen Bodenplan (240) und einen weiteren Bodenplan (242) einer vorbestimmten Bauwerksstruktur;
Empfangen einer Bezeichnung, von einem Benutzer, eines ersten und eines zweiten Bezugspunkts (250, 252) auf dem Bodenplan (240), wobei der zweite Bezugspunkt (252) auf dem Bodenplan (240) sich in einem Abstand A' von dem ersten Bezugspunkt (250) auf dem Bodenplan (240) befindet;
Empfangen einer Bezeichnung, von dem Benutzer, eines ersten Bezugspunkts (260) auf dem weiteren Bodenplan (242) und **gekennzeichnet durch** weitere folgende Schritte:
Positionieren, durch die elektronische Vorrichtung (100), eines zweiten Bezugspunkts (262) auf dem weiteren Bodenplan (242) in einem Abstand A von dem ersten Bezugspunkt (260) auf dem weiteren Bodenplan (242), wobei der Abstand A zwischen dem ersten und dem zweiten Bezugspunkt (260, 262) auf dem weiteren Bodenplan (242) äquidistant in Bezug auf den Abstand A' zwischen dem ersten und dem zweiten Bezugspunkt (250, 252) auf dem Bodenplan (240) ist;
Bewegen, durch den Benutzer, über eine Eingabevorrichtung (106) der elektronischen Vorrichtung (100), der Position des zweiten Bezugspunkts (262) auf dem weiteren Bodenplan (242), wobei das Bewegen unter der Steuerung der elektronischen Vorrichtung (100) mit der Beschränkung erfolgt, dass der zweite Bezugspunkt (262) in einem Abstand A von dem ersten Bezugspunkt (260) bleibt; und
Ausfluchten von mindestens dem Boden und dem weiteren Boden in Einklang mit der vorbestimmten Bauwerksstruktur, wobei das Ausfluchten vertikales Ausfluchten des ersten bereitgestellten Bezugspunkts (250) des Bodenplans (240) in Bezug auf den ersten Bezugspunkt (260) umfasst, welcher auf dem weiteren Bodenplan (242) bereitgestellt ist, und vertikales Ausfluchten des zweiten bereitgestellten Bezugspunkts (252) des Bodenplans (240) in Bezug auf den zweiten Bezugspunkt (262), welcher auf dem weiteren Bodenplan (242) bereitgestellt ist.

2. Verfahren nach Anspruch 1, ferner einschließend das Bereitstellen einer grafischen Animation von mindestens dem Bodenplan (240) und dem weiteren Bodenplan (242), welche miteinander ausgefluchtet werden, wenn der erste bereitgestellte Bezugspunkt des Bodenplans (240) vertikal mit dem ersten auf dem weiteren Bodenplan (242) bereitgestellten ersten Bezugspunkt ausgefluchtet wird, und wenn der zweite auf dem Bodenplan (240) bereitgestellte Bezugspunkt vertikal mit dem auf dem weiteren Bodenplan (242) bereitgestellten zweiten Bezugspunkt ausgefluchtet wird.

3. Verfahren nach Anspruch 1, wobei mindestens eine der folgenden Aussagen zutrifft:
die elektronische Vorrichtung (100) besitzt ein grafisches Display (108) zur Abbildung der Ausfluchtung von mindestens dem Bodenplan (240) und dem weiteren Bodenplan (242);
das grafische Display (108) besitzt eine Berührungsbildschirm-Benutzerschnittstelle.

4. Verfahren nach Anspruch 1, ferner einschließend den Schritt des Zugreifens, in der elektronischen Vorrichtung, auf mindestens den Bodenplan (240) und den weiteren Bodenplan (242).

5. Verfahren nach Anspruch 1, wobei jeder des ersten und des zweiten Bezugspunkts zugeordnete Kartierungskoordinaten besitzt, und wobei optionsweise:
die Kartierungskoordinaten, welche dem ersten und dem zweiten Referenzpunkt zugeordnet sind, aus Kartierungskoordinaten gewonnen werden, welche in den Bodenplänen (240, 242) bereitgestellt sind.

6. Gerät, welches eine grafische Benutzerschnittstelle (GUI) zum Ausfluchten von Bodenplänen (240, 242) einer Bauwerksstruktur aufweist, Folgendes umfassend:
einen Prozessor (102), welcher geeignet ist, einen oder mehrere Prozesse auszuführen;
einen Speicher (104), welcher konfiguriert ist, um durch den Prozessor (102) ausführbare Anweisungen zu speichern, wobei die Anweisungen, wenn sie durch den Prozessor (102) ausgeführt werden, den Prozessor (102) zu folgenden Schritten veranlassen:
Zugreifen auf mindestens einen Bodenplan (240) und einen weiteren Bodenplan (242) einer vorbestimmten Bauwerksstruktur;
Empfangen einer Bezeichnung, von einem Benutzer, eines ersten und eines zweiten Bezugspunkts (250, 252) auf dem Bodenplan (240), wobei der zweite Bezugspunkt (252) sich in einem Abstand A' von dem ersten Bezugspunkt (250) befindet;
Empfangen, von einem Benutzer, einer Bezeichnung eines ersten Bezugspunkts (260) auf dem weiteren Bodenplan (242);
Positionieren eines zweiten Bezugspunkts (262) auf dem weiteren Bodenplan (242), wie durch den Prozessor gerechnet (102), in einem Abstand A von dem ersten Bezugspunkt (242) auf dem weiteren Bodenplan (242), wobei der Abstand A zwischen dem ersten und dem zweiten Bezugspunkt (260, 262) auf dem weiteren Bodenplan (242) äquidistant in Bezug auf den Abstand A' zwischen dem ersten und dem zweiten Bezugspunkt (250, 252) auf dem Bodenplan (240) ist;
Bewegen, in Reaktion auf eine Eingabe des Benutzers über eine Eingabevorrichtung (106), der Position des zweiten Bezugspunkts (262) auf dem weiteren Bodenplan (242), wobei das Bewegen unter der Steuerung des Prozessors (102) mit der Beschränkung erfolgt, dass der zweite Bezugspunkt (262) auf dem weiteren Bodenplan (242) in einem Abstand A von dem ersten Bezugspunkt (260) auf dem weiteren Bodenplan (242) bleibt; und
Ausfluchten des Bodens und des weiteren Bodens in Einklang mit der vorbestimmten Bauwerksstruktur, wobei das Ausfluchten vertikales Ausfluchten des ersten bereitgestellten Bezugspunkts (250) des Bodenplans (240) mit dem ersten Bezugspunkt (260) umfasst, welcher auf dem weiteren Bodenplan (242) bereitgestellt ist, und vertikales Ausfluchten des zweiten bereitgestellten Bezugspunkts des (252) des Bodenplans (240) mit dem zweiten Bezugspunkt (262), welcher auf dem weiteren Bodenplan (242) bereitgestellt ist.

7. Gerät nach Anspruch 6, ferner einschließend Anweisungen zum Veranlassen des Prozessors (102) zum Bereitstellen einer grafischen Animation auf dem GUI von mindestens dem Bodenplan (240) und dem weiteren Bodenplan (242), welche miteinander ausgefluchtet werden, wenn der erste bereitgestellte Bezugspunkt (250) des Bodenplans (240) vertikal mit dem ersten auf dem weiteren Bodenplan (242) bereitgestellten ersten Bezugspunkt (260) ausgefluchtet wird, und der zweite auf dem Bodenplan (240) bereitgestellte Bezugspunkt (252) vertikal mit dem auf dem weiteren Bodenplan (242) bereitgestellten zweiten Bezugspunkt (262) ausgefluchtet wird.

8. Gerät nach Anspruch 6, wobei mindestens eine der folgenden Aussagen zutrifft:
die GUI besitzt eine Berührungsbildschirm-Benutzerschnittstelle.
das Gerät schließt ferner Anweisungen ein, um den Prozessor (102) anhand einer externen Eingabe dazu zu veranlassen, auf mindestens den Bodenplan (240) und den weiteren Bodenplan (242) zuzugreifen.

9. Gerät nach Anspruch 6, wobei jeder des ersten und des zweiten Bezugspunkts zugeordnete Kartierungskoordinaten besitzt, und wobei optionsweise:
die Kartierungskoordinaten, welche dem ersten und dem zweiten Referenzpunkt zugeordnet sind, aus Kartierungskoordinaten gewonnen werden, welche in den Bodenplänen (240, 242) bereitgestellt sind.

10. Gerät nach Anspruch 6, ferner einschließend Anweisungen zum Veranlassen des Prozessors (102), einen Benutzer in die Lage zu versetzen, mit der GUI zu interagieren, um den mindestens ersten und den mindestens zweiten Bezugspunkt auf jedem von dem Bodenplan (240) und dem weiteren Bodenplan (242) bereitzustellen.

11. Computerprogrammprodukt, umfassend ein durch einen Computer verwendbares Medium, welches eine darin gespeicherte Steuerlogik aufweist, um einen Computer dazu zu veranlassen, Bodenpläne einer Bauwerksstruktur auszufluchten, wobei die Steuerlogik Folgendes umfasst:
Code zum Veranlassen des Computers zum Zugreifen auf mindestens einen Bodenplan (240) und einen weiteren Bodenplan (242) einer vorbestimmten Bauwerksstruktur;
Code zum Veranlassen des Computers zum Empfangen eines durch einen Benutzer bezeichneten ersten und zweiten Bezugspunkts (250, 252) auf dem Bodenplan (240), wobei der zweite Bezugspunkt (252) auf dem Bodenplan (240) sich in einem Abstand A' von dem ersten Bezugspunkt (250) auf dem Bodenplan (240) befindet;
Code zum Veranlassen des Computers zum Empfangen eines durch einen Benutzer bezeichneten ersten Bezugspunkts (260) auf dem weiteren Bodenplan (242);
Code zum Veranlassen des Computers zum Positionieren eines zweiten Bezugspunkts (262) auf dem weiteren Bodenplan (242) in einem Abstand A von dem ersten Bezugspunkt (260) auf dem weiteren Bodenplan (242), wobei der Abstand A zwischen dem ersten und dem zweiten Bezugspunkt äquidistant in Bezug auf den Abstand A' zwischen dem ersten und dem zweiten Bezugspunkt (250, 252) auf dem Bodenplan (240) ist;
Code zum Veranlassen des Computers zum Bewegen, in Reaktion auf eine Eingabe des Benutzers über eine Eingabevorrichtung (106), der Position des zweiten Bezugspunkts (262) auf dem weiteren Bodenplan (242), wobei das Bewegen unter der Steuerung des Prozessors (102) mit der Beschränkung erfolgt, dass der zweite Bezugspunkt (262) auf dem weiteren Bodenplan (242) in einem Abstand A von dem ersten Bezugspunkt (260) auf dem weiteren Bodenplan (242) bleibt; und
Code zum Veranlassen des Computers zum Ausfluchten des Bodens und des weiteren Bodens in Einklang mit der vorbestimmten Bauwerksstruktur, wobei das Ausfluchten vertikales Ausfluchten des ersten bereitgestellten Bezugspunkts (250) des Bodenplans (240) mit dem ersten Bezugspunkt (260) umfasst, welcher auf dem weiteren Bodenplan (242) bereitgestellt ist, und vertikales Ausfluchten des zweiten bereitgestellten Bezugspunkte des (252) des Bodenplans (240) mit dem zweiten Bezugspunkt (262), welcher auf dem weiteren Bodenplan (242) bereitgestellt ist.

12. Computerprogrammprodukt nach Anspruch 11, ferner einschließend Code zum Veranlassen des Computers zum Bereitstellen einer grafischen Animation auf einer grafischen Benutzerschnittstelle (GUI) von mindestens dem Bodenplan (240) und dem weiteren Bodenplan (242), welche miteinander ausgefluchtet werden, wenn der erste bereitgestellte Bezugspunkt (250) des Bodenplans (240) mit dem ersten auf dem weiteren Bodenplan (242) bereitgestellten ersten Bezugspunkt (260) ausgefluchtet wird, und der zweite auf dem Bodenplan (240) bereitgestellte Bezugspunkt (252) mit dem auf dem weiteren Bodenplan (242) bereitgestellten zweiten Bezugspunkt (262) ausgefluchtet wird.

13. Computerprogrammprodukt nach Anspruch 11, wobei jeder von dem ersten und dem zweiten Bezugspunkt zugeordnete Kartierungskoordinaten besitzt, und wobei die Kartierungskoordinaten, welche dem ersten und dem zweiten Bezugspunkt zugeordnet sind, aus Kartierungskoordinaten gewonnen werden, welche in den Bodenplänen (240, 242) bereitgestellt sind.

## Revendications

1. Procédé pour aligner des plans d'implantation de niveau au moyen d'un dispositif électronique (100), le procédé comprenant les étapes constituées par :
l'accès à au moins un plan d'implantation de niveau (240) et un autre plan d'implantation de niveau (242) d'une structure de bâtiment prédéfinie ;
la réception d'une désignation, en provenance d'un utilisateur, de premier et second points de référence (250, 252) sur le plan d'implantation de niveau (240), dans lequel le second point de référence (252) sur le plan d'implantation de niveau (240) est à une distance A' du premier point de référence (250) sur le plan d'implantation de niveau (240) ;
la réception d'une désignation, en provenance de l'utilisateur, d'un premier point de référence (260) sur l'autre plan d'implantation de niveau (242) et **caractérisé par** les étapes supplémentaires constituées par :
le positionnement, par le dispositif électronique (100), d'un second point de référence (262) sur l'autre plan d'implantation de niveau (242) à une distance A du premier point de référence (260) sur l'autre plan d'implantation de niveau (242), dans lequel la distance A entre les premier et second points de référence (260, 262) sur l'autre plan d'implantation de niveau (242) est équidistante par rapport à la distance A' entre les premier et second points de référence (250, 252) sur le plan d'implantation de niveau (240) ;
le déplacement, par l'utilisateur via un dispositif d'entrée (106) du dispositif électronique (100), de la position du second point de référence (262) sur l'autre plan d'implantation de niveau (242), dans lequel le déplacement est sous la commande du dispositif électronique (100) avec pour contrainte que le second point de référence (262) reste à une distance A du premier point de référence (260) ; et
l'alignement d'au moins le niveau et l'autre niveau conformément à la structure de bâtiment prédéfinie, l'alignement comprenant l'alignement vertical du premier point de référence fourni (250) du plan d'implantation de niveau (240) par rapport au premier point de référence (260) fourni sur l'autre plan d'implantation de niveau (242) et l'alignement vertical du second point de référence fourni (252) du plan d'implantation de niveau (240) par rapport au second point de référence (262) fourni sur l'autre plan d'implantation de niveau (242).

2. Procédé tel que revendiqué selon la revendication 1, incluant en outre la fourniture d'une animation graphique d'au moins le plan d'implantation de niveau (240) et l'autre plan d'implantation de niveau (242) qui sont alignés l'un par rapport à l'autre lorsque le premier point de référence fourni du plan d'implantation de niveau (240) est en cours d'alignement vertical avec le premier point de référence fourni sur l'autre plan d'implantation de niveau (242) et lorsque le second point de référence fourni du plan d'implantation de niveau (240) est en cours d'alignement vertical avec le second point de référence fourni sur l'autre plan d'implantation de niveau (242).

3. Procédé tel que revendiqué selon la revendication 1, dans lequel au moins l'une des assertions qui suivent est satisfaite :
le dispositif électronique (100) comporte un affichage graphique (108) pour imager l'alignement d'au moins le plan d'implantation de niveau (240) et l'autre plan d'implantation de niveau (242) ; et
l'affichage graphique (108) comporte une interface utilisateur à écran tactile.

4. Procédé tel que revendiqué selon la revendication 1, incluant en outre l'étape d'accès, dans le dispositif électronique, à au moins le plan d'implantation de niveau (240) et l'autre plan d'implantation de niveau (242).

5. Procédé tel que revendiqué selon la revendication 1, dans lequel chacun des premier et second points de référence dispose de coordonnées de cartographie associées ; et
en option :
les coordonnées de cartographie qui sont associées aux premier et second points de référence sont extraites à partir de coordonnées de cartographie qui sont fournies dans les plans d'implantation de niveau (240, 242).

6. Appareil comportant une interface utilisateur graphique (GUI) pour aligner des plans d'implantation de niveau (240, 242) d'une structure de bâtiment, comprenant :
un processeur (102) qui est adapté pour exécuter un ou plusieurs processus ; et
une mémoire (104) qui est configurée pour stocker des instructions pouvant être exécutées par le processeur (102), les instructions, lorsqu'elles sont exécutées par le processeur (102), amenant le processeur (102) à :
accéder à au moins un plan d'implantation de niveau (240) et un autre plan d'implantation de niveau (242) d'une structure de bâtiment prédéfinie ;
recevoir une désignation, en provenance d'un utilisateur, de premier et second points de référence (250, 252) sur le plan d'implantation de niveau (240), dans lequel le second point de référence (252) est à une distance A' du premier point de référence (250) ;
recevoir, en provenance de l'utilisateur, une désignation d'un premier point de référence (260) sur l'autre plan d'implantation de niveau (242) ;
positionner un second point de référence (262) sur l'autre plan d'implantation de niveau (242), tel que calculé par le processeur (102), à une distance A du premier point de référence (260) sur l'autre plan d'implantation de niveau (242), dans lequel la distance A est équidistante par rapport à la distance A' entre les premier et second points de référence (250, 252) sur le plan d'implantation de niveau (240) ;
déplacer, en réponse à une entrée réalisée par l'utilisateur via un dispositif d'entrée (106), la position du second point de référence (262) sur l'autre plan d'implantation de niveau (242), dans lequel le déplacement est sous la commande du processeur (102) avec pour contrainte que le second point de référence (262) sur l'autre plan d'implantation de niveau (242) reste à la distance A du premier point de référence (260) sur l'autre plan d'implantation de niveau (242) ; et
aligner le niveau et l'autre niveau conformément à la structure de bâtiment prédéfinie, l'alignement comprenant l'alignement vertical du premier point de référence fourni (250) du plan d'implantation de niveau (240) par rapport au premier point de référence (260) fourni sur l'autre plan d'implantation de niveau (242) et l'alignement vertical du second point de référence fourni (252) du plan d'implantation de niveau (240) par rapport au second point de référence (262) fourni sur l'autre plan d'implantation de niveau (242).

7. Appareil tel que revendiqué selon la revendication 6, incluant en outre des instructions pour amener le processeur (102) à fournir une animation graphique sur la GUI d'au moins le plan d'implantation de niveau (240) et l'autre plan d'implantation de niveau (242) qui sont alignés l'un par rapport à l'autre lorsque le premier point de référence fourni (250) sur le plan d'implantation de niveau (240) est en cours d'alignement vertical avec le premier point de référence (260) fourni sur l'autre plan d'implantation de niveau (242) et lorsque le second point de référence fourni (252) du plan d'implantation de niveau (240) est en cours d'alignement vertical avec le second point de référence (262) fourni sur l'autre plan d'implantation de niveau (242).

8. Appareil tel que revendiqué selon la revendication 6, dans lequel au moins l'une des assertions qui suivent est satisfaite :
la GUI comporte une interface utilisateur à écran tactile ; et
l'appareil inclut en outre des instructions pour amener le processeur (102) à accéder, depuis une entrée externe, à au moins le plan d'implantation de niveau (240) et l'autre plan d'implantation de niveau (242).

9. Appareil tel que revendiqué selon la revendication 6, dans lequel chacun des premier et second points de référence dispose de coordonnées de cartographie associées ; et en option :
les coordonnées de cartographie qui sont associées aux premier et second points de référence sont extraites à partir de coordonnées de cartographie qui sont fournies dans les plans d'implantation de niveau (240, 242).

10. Appareil tel que revendiqué selon la revendication 6, incluant en outre des instructions pour amener le processeur (102) à permettre à un utilisateur d'interagir avec la GUI pour fournir les au moins premier et second points de référence sur chaque plan d'implantation parmi le plan d'implantation de niveau (240) et l'autre plan d'implantation de niveau (242).

11. Progiciel comprenant un support pouvant être utilisé par un ordinateur qui comporte, stockée en son sein, une logique de commande pour amener un ordinateur à aligner des plans d'implantation de niveau d'une structure de bâtiment, ladite logique de commande comprenant :
un code pour amener l'ordinateur à accéder à au moins un plan d'implantation de niveau (240) et un autre plan d'implantation de niveau (242) d'une structure de bâtiment prédéfinie ;
un code pour amener l'ordinateur à recevoir des premier et second points de référence désignés par utilisateur (250, 252) sur le plan d'implantation de niveau (240), dans lequel le second point de référence (252) sur le plan d'implantation de niveau (240) est à une distance A' du premier point de référence (250) sur le plan d'implantation de niveau (240) ;
un code pour amener l'ordinateur à recevoir un premier point de référence désigné par utilisateur (260) sur l'autre plan d'implantation de niveau (242) ;
un code pour amener l'ordinateur à positionner un second point de référence (262) sur l'autre plan d'implantation de niveau (242) à une distance A du premier point de référence (260) sur l'autre plan d'implantation de niveau (242), dans lequel la distance A entre les premier et second points de référence est équidistante par rapport à la distance A' entre les premier et second points de référence (250, 252) sur le plan d'implantation de niveau (240) ;
un code pour amener l'ordinateur à déplacer, en réponse à une entrée réalisée par l'utilisateur via un dispositif d'entrée (106), la position du second point de référence (262) sur l'autre plan d'implantation de niveau (242), dans lequel le déplacement est sous la commande du processeur (102) avec pour contrainte que le second point de référence (262) sur l'autre plan d'implantation de niveau (242) reste à la distance A du premier point de référence (260) sur l'autre plan d'implantation de niveau (242) ; et
un code pour amener l'ordinateur à aligner le niveau et l'autre niveau conformément à la structure de bâtiment prédéfinie, l'alignement comprenant l'alignement vertica du premier point de référence fourni (250) du plan d'implantation de niveau (240) par rapport au premier point de référence (260) fourni sur l'autre plan d'implantation de niveau (242) et l'alignement vertical du second point de référence fourni (252) du plan d'implantation de niveau (240) par rapport au second point de référence (262) fourni sur l'autre plan d'implantation de niveau (242).

12. Progiciel tel que revendiqué selon la revendication 11, incluant en outre un code pour amener l'ordinateur à fournir une animation graphique, sur une interface utilisateur graphique (GUI), d'au moins le plan d'implantation de niveau (240) et l'autre plan d'implantation de niveau (242) qui sont alignés l'un par rapport à l'autre lorsque le premier point de référence fourni (250) du plan d'implantation de niveau (240) est en cours d'alignement avec le premier point de référence (260) fourni sur l'autre plan d'implantation de niveau (242) et lorsque le second point de référence fourni (252) sur le plan d'implantation de niveau (240) est en cours d'alignement avec le second point de référence (262) fourni sur l'autre plan d'implantation de niveau (242).

13. Progiciel tel que revendiqué selon la revendication 11, dans lequel chacun des premier et second points de référence dispose de coordonnées de cartographie associées, et dans lequel les coordonnées de cartographie qui sont associées aux premier et second points de référence sont extraites à partir de coordonnées de cartographie qui sont fournies dans les plans d'implantation de niveau (240, 242).
